# EUROPÄISCHE PATENTSCHRIFT

(11) **EP 0 433 814 B1**
(45) Veröffentlichungstag und Bekanntmachung des Hinweises auf die Patenterteilung: **10.11.1993**
(21) Anmeldenummer: 90123621.6
(22) Anmeldetag: 08.12.1990
(51) Int. Cl.: H01H 13/70

(54) **Drucktastenanordnung**
Keyboard
Clavier à touches

(30) Priorität: 18.12.1989 DE 3941712
(43) Veröffentlichungstag der Anmeldung: 26.06.1991
(73) Patentinhaber: Alcatel SEL Aktiengesellschaft, D-70435 Stuttgart (DE); ALCATEL N.V., NL-1077 XX Amsterdam (NL)
(72) Erfinder: Deeg, Reinhard, W-7538 Keltern 2 (DE)
(74) Vertreter: Pohl, Herbert, Dipl.-Ing.

(56) Entgegenhaltungen:
- EP-A- 0 005 175
- EP-A- 0 078 036
- DE-U- 8 800 951
- FR-A- 2 454 684
- GB-A- 2 046 519
- GB-A- 2 201 038

## Beschreibung

Die Erfindung betrifft eine Drucktastenanordnung nach dem Oberbegriff des Anspruchs 1.

Eine derartige Anordnung ist in der GB-A-2 201 038 beschrieben, die eine Tastatur mit beleuchteten Tasten betrifft. Die Tasten sind im Gehäuse der Tastatur geführt und wirken beim Drücken auf Dome einer elastischen Schaltmatte, die jeweils Kontakte enthalten, welche mit Kontakten einer Leiterfolie in Berührung kommen. Letztere liegt unter der Schaltmatte auf einer transparenten Platte, die auf der Unterseite Ansätze aufweist, die einen bestimmten Abstand zu einer darunter im Gehäuse angebrachten Leiterplatte halten. Die Ansätze sind mit Zapfen zur Lagefixierung ausgerüstet, die in Löcher der Leiterplatte eingreifen. Auf der Unterseite dieser Leiterplatte sitzen Leuchtidioden, ihre Oberseite trägt die Leiterbahnen mit den gelöteten Anschlüssen der Leuchtdioden. Die transparente Platte ist außerdem auf beiden Seiten mit angeformten Ansätzen versehen, die jeweils paarweise koaxial nach oben und unten vorstehen, wobei sich die oberen Ansätze jeweils in den Hohlraum einer Taste erstrecken, während die unteren Ansätze jeweils vor eine Leuchtdiode geführt sind.

Ferner ist aus der DE-A1-33 43 321 eine Wähltastatur für Telefone bekannt, bei der die Tasten ebenfalls im Gehäuse der Tastatur geführt sind und auf Dome einer elastischen Schaltmatte wirken, welche Kontakte enthalten, die mit Kontakten einer Kontaktplatte in Berührung kommen. Die Kontaktplatte kann eine Leiterplatte sein, die auf der der Schaltmatte zugewandten Seite (Oberseite) außer den Kontakten auch die anschließenden Leiterbahnen trägt. Notwendige elektrische Bauelemente konnen, wie üblich, auf der Unterseite der Leiterplatte angeordnet werden. Da die Fläche relativ klein ist, kann es besonders bei komfortablen Telefonen vorkommen, daß die elektrischen Bauelemente nur zum Teil auf der Leiterplatte der Tastatur untergebracht werden können. Der andere Teil muß andernorts im Gerät befestigt werden.

Der Erfindung liegt die Aufgabe zugrunde, die Aufnahmefähigkeit der Tastenanordnung für elektrische Bauelemente zu steigern. Gelöst wird diese Aufgabe durch die im Anspruch 1 angegebenen Merkmale. Weiterbildungen sind den Unteransprüchen zu entnehmen. Der Vorteil dieser Konstruktion liegt nicht nur in einer wesentlichen Steigerung der Bauelemente, die auf der Leiterplatte befestigbar sind, sondern auch darin, daß die Anordnung von der Leiterplatte bis zur Schaltmatte ohne besondere Befestigungsmittel gefügt werden kann und danach eine vollständige, prüfbare, kostengünstige Baugruppe darstellt. Weitere Vorteile sind in der Beschreibung angeführt.

Die Erfindung wird an einem Ausführungsbeispiel beschrieben, das in den zugehörigen Zeichnungen dargestellt ist. Darin zeigen:
- Fig. 1: einen Längsschnitt durch eine Drucktaste einer erfindungsgemäßen Drucktastenanordnung;
- Fig. 2: eine Drucktastenanordnung mit dem Tastenaufbau nach Fig. 1, in Ansicht von der Leiterplattenseite, ohne Schaltmatte, Tasten und Gehäuse, und
- Fig. 3: die Anordnung nach Fig. 2 in Seitenansicht.

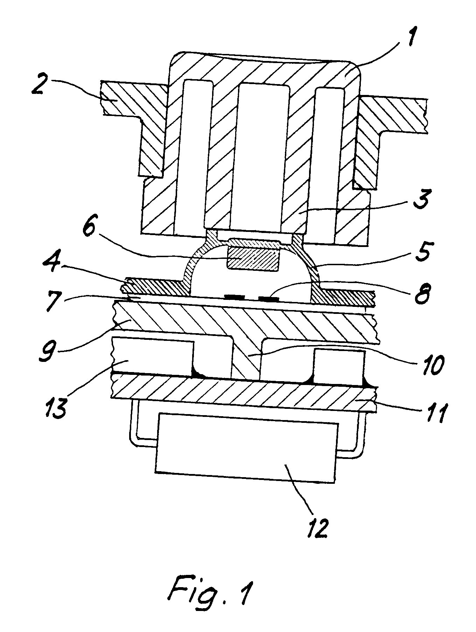

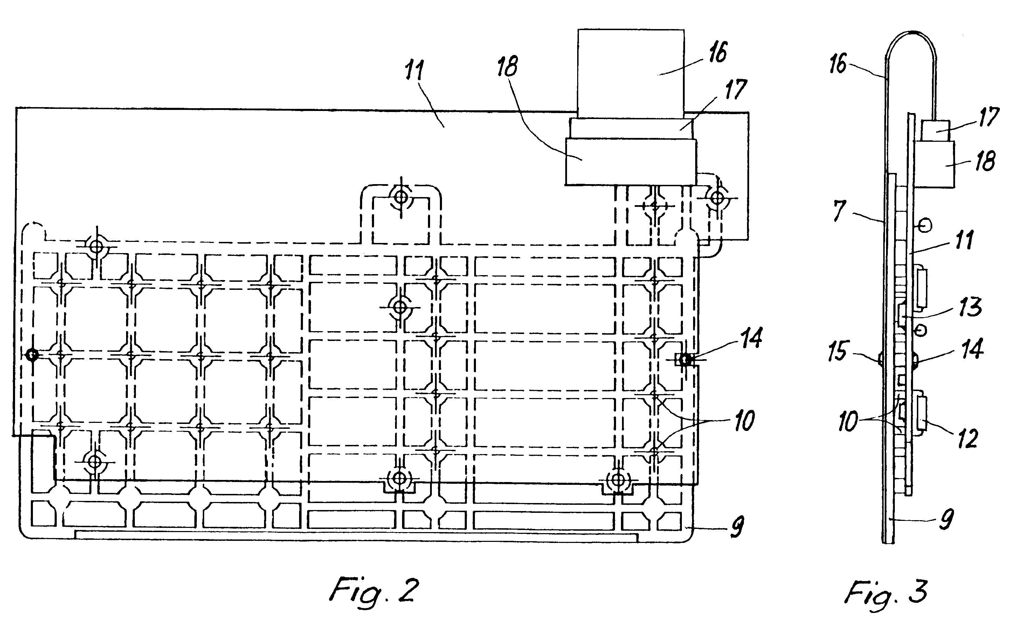

Aus Fig. 1 ist der Aufbau einer Drucktaste aus der in Fig. 2 und 3 gezeigten Anordnung im Schnitt dargestellt. Der Druckknopf 1 ist in einem Gehäuse 2 geführt und hat im Innern einen Hohlzylinder 3. Dieser Hohlzylinder 3 sitzt mit seinem Rand auf einem Dom 5 einer elastischen Schaltmatte 4. Im Innern des Domes 5 ist in seiner Kuppel ein Kontakt 6 angebracht. Derartige Schaltmatten sind handelsüblich.

Beim Niederdrücken des Druckknopfes 1 wird der Dom 5 eingedrückt, wobei der Kontakt 6 mit Kontakten 8 einer Leiterfolie 7 in Berührung kommt, die unter der Schaltmatte 4 angeordnet ist. Andererseits liegt die Leiterfolie 7 auf einem Distanzrahmen 9, der den Abstand zu einer Leiterplatte 11 herstellt, die beiderseits mit elektrischen Bauelementen 12 und 13 bestückt ist.

Der Distanzrahmen 9 ist gitterförmig gestaltet, wobei Kreuzungsstellen der Gitterstäbe, im folgenden Gitterknoten genannt, jeweils unter den Drucktasten liegen. Die Höhe der Gitterstäbe ist geringer als der Abstand von der Leiterfolie 7 zur Leiterplatte 11, der fehlende Teil wird von Abstandszapfen 10 überbrückt, die jeweils in den Gitterknoten am Distanzrahmen 9 sitzen. Die Gitterknoten können zylindrische Verdickungen haben. Zweckmäßig ist der ganze Distanzrahmen 9 für eine vorgesehene Drucktastenanordnung, wie sie aus Fig. 2 ersichtlich ist, einstückig aus Kunststoff geformt, samt der Abstandszapfen 10 an den Gitterknoten, sowie weiterer Rastzapfen 14, die die Leiterplatte 11 durchsetzen und hinter der Öffnungskante rasten. Auf der anderen Seite des Distanzrahmens 9 sind ebenfalls Rastzapfen 15 angeformt, mit deren Hilfe die Leiterfolie 7 festgelegt wird (Fig. 3).

Die Leiterplatte 11 kann, wie aus Fig. 1 und 3 hervorgeht, in vorteilhafter Weise beiderseits mit Bauelementen 12 und 13 voll bestückt werden. Die Bestückung der zweiten, innenliegenden Oberseite wird durch den Distanzrahmen 9 ermöglicht. Bei dem in Fig. 1 dargestellten Beispiel ist eine einseitig beschichtete Leiterplatte eingesetzt, wobei die Schicht- bzw.

Leiterbahnenseite dem Distanzrahmen zugewandt ist. Diese Seite ist mit oberflächenmontierten Bauelementen (OMB) 13 bestückt, die andere Seite mit konventionellen Bauelementen 12. Doch können auch andere Leiterplatten mit zwei oder mehr Schichten und anderer Bestückung verwendet werden. Sollen auch auf der Oberseite die größeren konventionellen Bauelemente 12 angebracht werden, so ist das Layout der Leiterplatte so auszulegen, daß diese Bauelemente in den Zwischenräumen des Gitters des Distanzrahmens 9 sitzen.

Bei der Darstellung in Fig. 2 und 3 sind Schaltmatte 4 sowie Druckknöpfe 1 und Gehäuse 2 nicht eingezeichnet. So stellt sich die Schaltungsbaugruppe der Drucktastenanordnung dar. Die Anschlüsse der Leiterfolie 7 sind über eine Zunge 16 auf einen Stecker 17 geführt, der an eine Kontaktleiste 18 auf der Leiterplatte 11 angesteckt ist. Diese Baugruppe kann vorgefertigt, geprüft und gelagert werden. In Fig. 2 sind außerdem die Bauelemente auf der Leiterplatte 11 der Übersichtlichkeit halber weggelassen. Statt dessen ist auch der nicht sichtbare Teil des Distanzrahmens 9 gestrichelt eingezeichnet, um die Gitterstruktur sichtbar zu machen.

Durch die Anordnung der Abstandszapfen 10 in den Gitterknoten unter den Drucktasten wird eine sichere Kontaktgabe zwischen den Kontakten 6 und 8 gewährleistet. Der Distanzrahmen 9 stützt sich dabei über die Abstandszapfen 10 gegen die Leiterplatte 11 ab. Da die Gitterstäbe des Distanzrahmens elastisch sind und die Druckknöpfe 1 bei Betätigung jeweils mit ihrem Außenmantel ringförmig aufsetzen, findet ein geringer Nachhub statt, der schaltungstechnisch von Vorteil ist.

## Patentansprüche

1. Drucktastenanordnung mit Tasten, die auf Dome (5) einer elastischen Schaltmatte (4) wirken, wobei jeder Dom (5) einen Schaltkontakt (6) aufweist, der mit Kontakten (8) einer Leiterfolie (7) zusammen wirkt, die unter der Schaltmatte (4) angeordnet ist und auf einem Distanzrahmen (9) liegt, der den Abstand zu einer Leiterplatte (11) herstellt,
**dadurch gekennzeichnet**, daß der Distanzrahmen (9) gitterförmig gestaltet ist, wobei die Gitterknoten des Distanzrahmens (9) jeweils unter den Kontakten (6, 8) liegen und auf der der Leiterplatte (11) zugewandten Seite einen Abstandszapfen (10) tragen, daß die Leiterplatte (11) auf beiden Seiten mit Bauelementen (12, 13) bestückt ist, und daß das Layout der Leiterplatte (11) so gestaltet ist, daß die Bauelemente (13) auf der dem Distanzrahmen (9) zugewandten Seite in den Öffnungen des gitterförmigen Distanzrahmens (9) liegen.

2. Drucktastenanordnung nach Anspruch 1, dadurch gekennzeichnet, daß der Distanzrahmen (9) beiderseits mit Rastzapfen (14, 15) ausgerüstet ist, die einerseits in entsprechende Öffnungen der Leiterplatte (11) und andererseits in Öffnungen der Leiterfolie (7) ein- rasten.

## Claims

1. A push-button arrangement including keys which act on the domes (15) of an elastic switching pad (4), with each dome (5) being provided with a switching contact (6) that cooperates with the contacts (8) of a conductor foil (7) disposed underneath the switching pad (4) and being seated on a spacer frame (9) which establishes the distance from a printed circuit board (11) characterised in that the spacer frame (9) has the shape of a lattice, with the lattice nodes of the spacer frame (9) each lying under a contact (6, 8) and being equipped, on their sides facing the printed circuit board (11), with a spacer pin (10); both sides of the printed circuit board (11) are equipped with components (12, 13) and the layout of the printed circuit board (11) is such that, on their sides facing the spacer frame (9), the components (13) are seated in the openings of the lattice shaped spacer frame (9).

2. A push-button arrangement according to Claim 1, characterised in that both sides of the spacer frame (9) are equipped with detent pins (14, 15) which, on the one hand, latch into corresponding openings in the printed circuit board (11) and, on the other hand, into openings in the conductor foil (7).

## Revendications

1. Clavier à touches qui, lorsqu'on les enfonce, agissent sur des dômes (5) d'une housse élastique (4) de mise en circuit, clavier dans le cas duquel chaque dôme (5) présente un contact de mise en circuit (6) qui collabore avec des contacts (8) d'une feuille de circuit imprimé (7) qui est disposée sous la housse de mise en contact (4) et repose sur un cadre d'écartement (9) qui assure l'écartement par rapport à une plaquette de circuit imprimé (11),
clavier caractérisé par le fait que le cadre d'écartement (9) a la forme d'une grille, les noeuds de la grille du cadre d'écartement (9) étant chacun situés sous les contacts (6, 8) et portant un téton d'écartement (10) du côté orienté vers la plaquette de circuit imprimé (11), par le fait que la plaquette de circuit imprimé (11) est garnie, sur ses deux faces, de composants (12, 13) et par le fait que l'implantation de la plaquette de circuit imprimé (11) est réalisée de façon telle que les composants (13), du côté orienté vers le cadre d'écartement (9), sont situés dans les ouvertures du cadre d'écartement en forme de grille (9).

2. Clavier à touches selon la revendication 1, caractérisé par le fait que le cadre d'écartement (9) est équipé, des deux côtés, de tétons de crantage (14, 15) qui se crantent d'une part dans les ouvertures correspondantes de la plaquette de circuit imprimé (11) et d'autre part dans des ouvertures de la feuille de circuit imprimé (7).
